# EUROPEAN PATENT SPECIFICATION

(11) **EP 2 551 909 B1**
(45) Date of publication and mention of the grant of the patent: **25.03.2015**
(21) Application number: 12177721.3
(22) Date of filing: 24.07.2012
(51) Int. Cl.: H01L 27/146

(54) **Simplified light sensing circuit, light sensing apparatus including the light sensing circuit, method of driving the light sensing apparatus, and image acquisition apparatus and optical touch screen apparatus including the light sensing apparatus**
Vereinfachte Lichtsensorschaltung, Lichtsensorvorrichtung mit der Lichtsensorschaltung, Verfahren zum Ansteuern der Lichtsensorvorrichtung und Bilderfassungsvorrichtung und optische Berührungsbildschirmvorrichtung mit der Lichtsensorvorrichtung
Circuit de détection de lumière simplifiée, appareil de détection de lumière comprenant le circuit de détection de lumière, procédé de commande de l'appareil de détection de lumière, et appareil d'acquisition d'image et appareil à écran tactile optique comprenant l'appareil de détection de lumière

(30) Priority: 25.07.2011 KR 20110073779
(43) Date of publication of application: 30.01.2013
(73) Proprietor: Samsung Electronics Co., Ltd., Suwon-si, Gyeonggi-do, 443-742 (KR)
(72) Inventor: Kim, Young, 449-712 Gyeonggi-do (KR); Song, I-hun, 449-712 Gyeonggi-do (KR); Jeon, Sang-hun, 449-712 Gyeonggi-do (KR); Ahn, Seung-eon, 449-712 Gyeonggi-do (KR)
(74) Representative: Greene, Simon Kenneth

(56) References cited:
- EP-A2- 2 341 542
- WO-A1-2007/120010
- US-A1- 2008 122 804
- US-A1- 2010 097 838
- US-A1- 2011 141 060
- US-A1- 2011 261 017

## Description

### BACKGROUND

### 1. Field

The present disclosure relates to a light sensing apparatus having a simplified structure using an oxide semiconductor transistor capable of sensing light as a light sensing device, a method of driving the light sensing apparatus, and an optical touch screen apparatus including the light sensing apparatus.

### 2. Description of the Related Art

Touch screen devices are devices which may directly receive input data through a screen by recognizing a position of, for example, a finger, a stylus, or the like, touching the screen and performing a particular process by a software routine. To this end, a touch screen device may be equipped with a touch panel to perform the above function. Such touch panels may include resistive overlay type touch panels, capacitive overlay type touch panels, surface acoustic wave (SAW) type touch panels, infrared beam type touch panels, piezoelectric type touch panels, or the like. The touch screen device is widely used in a variety of fields as an input device replacing a keyboard or a mouse.

A touch screen device that has been widely used employs a method of directly touching a screen of a display device using a finger or a stylus. However, as the size of a display device increases, the distance between the display device and a user may increase. In this case, use of the direct touch method may be difficult to adopt. Accordingly, optical touch screen devices have been proposed that may perform the same function as the existing touch screen by sensing light instead of sensing contact of a finger or a stylus. An optical touch screen device may facilitate communications not only between a user and a terminal but also between a user and a user.

In order to realize such an optical touch panel, a relatively small sized light sensing device for sensing light may be required. An amorphous silicon thin film transistor (a-Si TFT) is one of generally used light sensing devices. However, an a-Si TFT may not exhibit a sufficient current change according to light. Accordingly, when light is incident, electric charges generated in a photodiode are accumulated in a capacitor for a predetermined period of time and then a signal related to light intensity may be generated from the quantity of electric charges accumulated in the capacitor. When a capacitor is used as above, a sensing time may be delayed as long as the time for accumulating electric charges in a capacitor. Also, as the size of an optical touch screen device increases, parasitic capacitance may increase as well.

US 2010/0097838 describes an optical sensor with an oxide semiconductor layer in which light is received during a light reception phase and read out during a light readout period with a voltage applied to the gate.

WO2007/120010 describes an oxide semiconductor device, as does EP 2 341 542.

Image display units with a screen input function are described in US 2008/0122804, US2011/0141060 and US 2011/0261017, the last being published 27 October 2011.

### SUMMARY

Provided is a light sensing apparatus including the light sensing circuit, a method of driving the light sensing apparatus, and an optical touch screen apparatus including the light sensing apparatus.

In a first aspect of the invention there is provided a light sensitive apparatus according to claim 1.

The light sensing circuit may further include a gate line connected to a gate of the oxide semiconductor transistor and configured to provide a gate voltage, a drive voltage line connected to a drain of the oxide semiconductor transistor and configured to provide a drive voltage, and a data line connected to a source of the oxide semiconductor transistor and configured to provide data.

The light sensing circuit may further include a gate driver configured to provide the gate voltage to the gate of the oxide semiconductor transistor via the gate line. The gate driver may be configured such that the gate voltage is any one of a first voltage that is lower than a first threshold voltage, a second voltage that is between the first threshold voltage and a second threshold voltage, and a third voltage that is positive, the first threshold voltage being a threshold voltage of the oxide semiconductor transistor when light is incident on the oxide semiconductor transistor, the second threshold voltage being a threshold voltage of the oxide semiconductor transistor when light not incident on the oxide semiconductor transistor.

The light sensing circuit may further include a gate line connected to both of a gate and a drain of the oxide semiconductor transistor and configured to provide a gate voltage; and a data line connected to a source of the oxide semiconductor transistor and configured to provide data.

The oxide semiconductor transistor may include a substrate, a gate disposed on at least a portion of the substrate, a gate insulation film on the substrate and the gate to cover at least the gate, a channel layer disposed on the gate insulation film to face the gate, a source and a drain disposed to cover opposite sides of the channel layer, and a transparent insulation layer disposed to cover the source, the drain, and the channel layer, wherein the channel layer is formed on the gate insulation film and facing the gate.

The oxide semiconductor transistor may further include a first conductive plug that passes through the transparent insulation layer and is electrically connected to the source; a first contact on the transparent insulation that electrically contacts the first conductive plug; a second conductive plug that passes through the transparent insulation layer and is electrically connected to the drain; and a second contact on the transparent insulation layer that electrically contacts the second conductive plug.

The oxide semiconductor transistor may include a substrate; a gate insulation film on at least a central portion of the channel layer; a gate on the gate insulation film that faces the channel layer; a source and a drain on the channel layer at opposite sides of the gate, the source and drain each being separate from the gate; and a transparent insulation layer covering the gate, the source, and the drain, the channel layer being on the substrate.

The oxide semiconductor material may include one or more of ZnO, InO, SnO, InZnO, ZnSnO, or InSnO, or a material formed by adding at least one of Hf, Zr, Ti, Ta, Ga, Nb, V, Al, and Sn to one of ZnO, InO, SnO, InZnO, ZnSnO, or InSnO.

The gate driver may be configured to apply the gate voltage to the oxide semiconductor transistors sequentially in the row direction, and to apply the reset signal to all of the oxide semiconductor transistors at a time after applying the gate voltage to the oxide semiconductor transistors sequentially in the row direction.

The gate driver may provide each oxide semiconductor transistor with a first voltage that is lower than a first threshold voltage, a second voltage that is between the first threshold voltage and a second threshold voltage, and a third voltage that is positive, the first threshold voltage being a threshold voltage of the oxide semiconductor transistor when light is incident on the oxide semiconductor transistor, the second threshold voltage being a threshold voltage of the oxide semiconductor transistor when light not incident on the oxide semiconductor transistor.

The gate driver may be configured to provide the gate voltage to each oxide semiconductor transistor in order of the first voltage, the second voltage, the first voltage, and the third voltage, and the third voltage is the reset signal to reset the oxide semiconductor transistor.

Each gate line may be connected to light sensing pixels, from among the plurality of light sensing pixels that are in the same row.

Gates of the oxide semiconductor transistors of the plurality of light sensing pixels in a row may be connected to the gate line of the same row.

The light sensing apparatus may further include a signal output unit that includes a plurality of data lines arranged in a column direction, the signal output unit being configured to receive a light sensing signal from each of the plurality of light sensing pixel and output a data signal.

Sources of the oxide semiconductor transistors of the plurality of light sensing pixels in a column may be connected to the data line of the same column.

The signal output unit may include an A/D converter configured to convert analog signals output from the plurality of light sensing pixels into digital signals, a buffer configured to temporarily store the digital signals, and a column scanner configured to select an output from one of the plurality of light sensing pixels in a column.

According to another aspect of the present invention, an optical touch screen apparatus includes a display apparatus configured to display an image, an optical touch panel attached on a screen of the display apparatus and including the above light sensing apparatus, and a light source apparatus configured to provide an optical signal to the optical touch panel.

According to another aspect of the present invention, there is provided a method of driving a light sensing apparatus according to claim 12.

The third voltage is a reset signal that resets the oxide semiconductor transistor. The method may further include measuring current flowing between a drain and a source of the oxide semiconductor transistor during the application of the second voltage to a gate of the oxide semiconductor transistor.

### BRIEF DESCRIPTION OF THE DRAWINGS

The above and other features and advantages of example embodiments will become more apparent by describing in detail example embodiments with reference to the attached drawings. The accompanying drawings are intended to depict example embodiments and should not be interpreted to limit the intended scope of the claims. The accompanying drawings are not to be considered as drawn to scale unless explicitly noted.
FIG. 1 is a cross-sectional view schematically illustrating a structure of an oxide semiconductor transistor used as a light sensing device according to example embodiments;
FIG. 2 is a cross-sectional view schematically illustrating a structure of an oxide semiconductor transistor used as a light sensing device according to example embodiments;
FIGS. 3 and 4 are graphs showing operation characteristics of the oxide semiconductor transistors of FIGS. 1 and 2;
FIG. 5 is a circuit diagram illustrating a structure of a light sensing circuit according to example embodiments;
FIG. 6 schematically illustrates operation characteristics and a driving method of an oxide semiconductor transistor in the light sensing circuit of FIG. 5;
FIG. 7 is a block diagram schematically illustrating a structure of a light sensing apparatus according to example embodiments including the light sensing circuit of FIG. 5;
FIG. 8 schematically illustrates a structure of a light sensing pixel array of the light sensing apparatus of FIG. 7;
FIG. 9 is a timing diagram showing a method of driving the light sensing apparatus of FIG. 7;
FIG. 10 is a circuit diagram illustrating a structure of a light sensing circuit according to example;
FIG. 11 schematically illustrates operation characteristics and a driving method of an oxide semiconductor transistor in the light sensing circuit of FIG. 10; and
FIG. 12 is a perspective view of an optical touch screen apparatus according to example embodiments in which the light sensing apparatus of FIG. 7 is used as a light touch panel.

### DETAILED DESCRIPTION

Detailed example embodiments are disclosed herein. However, specific structural and functional details disclosed herein are merely representative for purposes of describing example embodiments. Example embodiments may, however, be embodied in many alternate forms and should not be construed as limited to only the embodiments set forth herein.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but to the contrary, example embodiments are to cover all modifications, equivalents, and alternatives falling within the scope of example embodiments. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or" includes any and all combinations of one or more of the associated listed items.

It will be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between", "adjacent" versus "directly adjacent", etc.).

The terminology used herein is for the purpose of describing particular embodiments only and is not intended to be limiting of example embodiments. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

It should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

An oxide semiconductor transistor is, for example, a transistor in which an oxide semiconductor is used as a material for a channel. The oxide semiconductor transistor may have a characteristic of being sensitive to light according to a material for an oxide semiconductor that is used as a channel layer. When an oxide semiconductor material having such a characteristic is used as a channel layer, an oxide semiconductor transistor may be **characterized in that** a threshold voltage and a drain current change according to a wavelength or light quantity of incident light. Accordingly, the oxide semiconductor transistor may be used as a light sensing device.

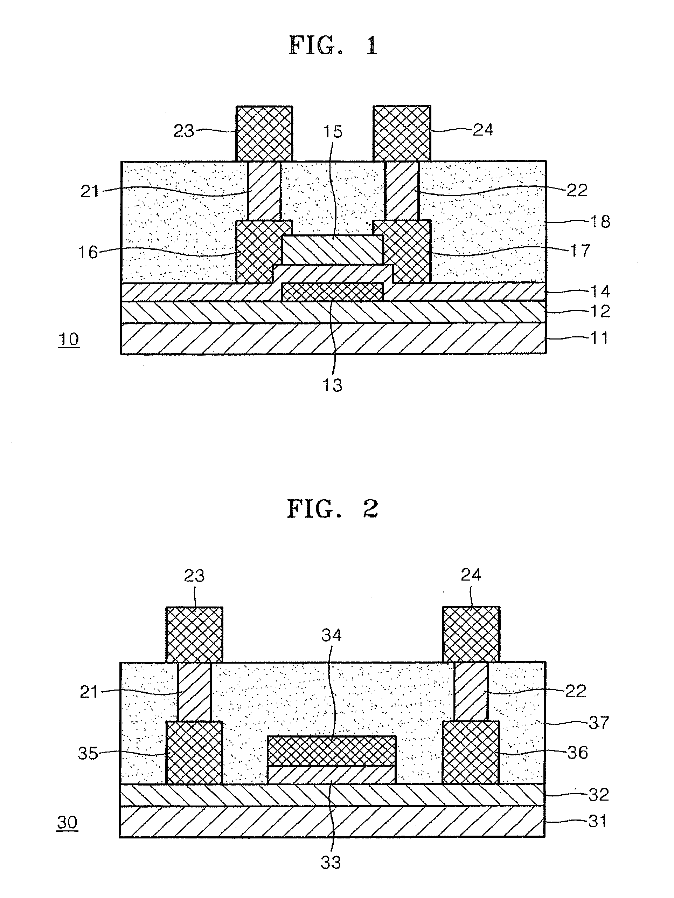

FIG. 1 is a cross-sectional view schematically illustrating a structure of an oxide semiconductor transistor 10 used as a light sensing device according to example embodiments. Referring to FIG. 1, the oxide semiconductor transistor 10 may include a substrate 11, an insulation layer 12 disposed on the substrate 11, a gate 13 disposed, for example partially, on the insulation layer 12, a gate insulation film 14 disposed on the insulation layer 12 and a channel layer 15 to cover at least the gate 13, the channel layer 15 disposed on the gate insulation film 14 to face the gate 13, a source 16 and a drain 17 disposed to cover the opposite sides of the channel layer 15, and a transparent insulation layer 18 disposed to cover the source 16, the drain 17, and the channel layer 15. Also, the oxide semiconductor transistor 10 may include a first conductive plug 21 electrically connected to the source 16 by passing through the transparent insulation layer 18 for electrical connection to the source 16, a first contact 23 formed on the transparent insulation layer 18 to electrically contact the first conductive plug 21, a second conductive plug 22 electrically connected to the drain 17 by passing through the transparent insulation layer 18 for electrical connection to the drain 17, and a second contact 24 formed on the transparent insulation layer 18 to electrically contact the second conductive plug 22.

The substrate 11 may use a general substrate material, for example, glass, silicon, or the like. The insulation layer 12, the gate insulation film 14, and the transparent insulation layer 18 may use a material such as SiO₂. When the substrate 11 is formed of an insulation material, the insulation layer 12 on the substrate 11 may be omitted. Also, the gate 13, the source 16, and the drain 17 may use a conductive metal or conductive metal oxide. For example, the oxide semiconductor transistor 10 that is sensitive to light may be used for an optical touch panel that is attached to a display panel, the gate 13, the source 16, and the drain 17 may be formed of a transparent conductive material such as indium tin oxide (ITO). However, when the oxide semiconductor transistor 10 is not transparent, materials for the substrate 11, the insulation layer 12, the gate 13, the gate insulation film 14, the source 16, and the drain 17 may not be transparent. According to example embodiments, only the transparent insulation layer 18 in the upper portion may be transparent in order to guide light toward the channel layer 15.

The channel layer 15 is formed of an oxide semiconductor material, as described above. The oxide semiconductor transistor 10 may have a light sensitive characteristic according to an oxide semiconductor material for the channel layer 15. For example, an oxide semiconductor material such as ZnO, InO, SnO, InZnO, ZnSnO, and InSnO may be used as an oxide semiconductor channel material, or a material formed by adding at least one of Hf, Zr, Ti, Ta, Ga, Nb, V, Al, and Sn to the above-described oxide semiconductor material may be used as the oxide semiconductor channel material. When the above material is used for the channel layer 15, the oxide semiconductor transistor 10 of FIG. 1 may exhibit a threshold voltage and a drain current that change according to the wavelength or light quantity of incident light and may be used as a light sensing device. The channel layer 15 may be formed of a single oxide semiconductor layer or may have a multilayer structure.

FIG. 1 illustrates the oxide semiconductor transistor 10 having a bottom-gate structure in which a gate is arranged under a channel. However, according to example embodiments a light sensing device may include an oxide semiconductor transistor having a top-gate structure. For example, FIG. 2 is a cross-sectional view schematically illustrating a structure of an oxide semiconductor transistor 30 having a top-gate structure according to example embodiments.

Referring to FIG. 2, according to example embodiments, the oxide semiconductor transistor 30 may include a substrate 31, a channel layer 32 disposed on the substrate 31, a gate insulation film 33 disposed, for example partially, on a central area of the channel layer 32, a gate 34 disposed on the gate insulation film 33 to face the channel layer 32, a source 35 and a drain 36 disposed on the channel layer 32 to be separated from the opposite sides of the gate 34, and a transparent insulation layer 37 disposed to cover the gate 34, the source 35, and the drain 36. According to example embodiments, In the oxide semiconductor transistor 30 having a top-gate structure of FIG. 2, in order for light to be incident upon the channel layer 32, the gate 34, the source 35, and the drain 36 may be formed of a transparent conductive material such as ITO. Also, the oxide semiconductor transistor 30 of FIG. 2 may further include the first conductive plug 21, the first contact 23, the second conductive plug 22, and the second contact 24.

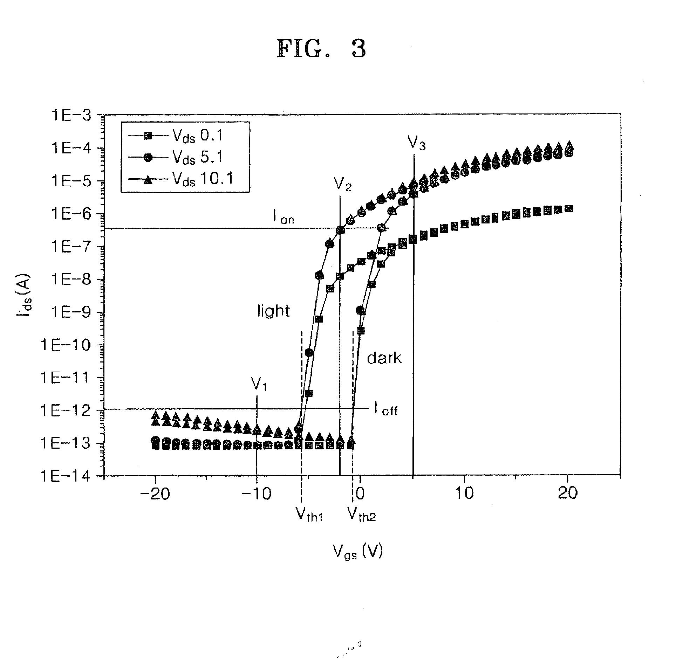

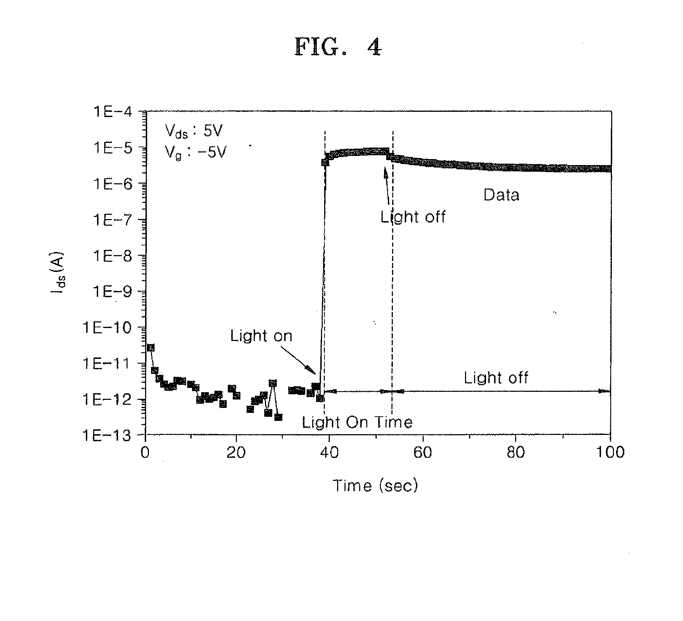

FIGS. 3 and 4 are graphs showing operation characteristics of the oxide semiconductor transistor 10 of FIG. 1 and the oxide semiconductor transistor 30 of FIG. 2 according to example embodiments. First, FIG. 3 shows a characteristic of a drain current Ids with respect to a gate voltage Vgs for either the oxide semiconductor transistor 10 illustrated in FIG. 1 or the oxide semiconductor 30 illustrated in FIG. 2. The characteristic is shown for drain-to-source voltages Vds of 0.1, 5.1 and 10.1.

FIG. 3 illustrates first and second threshold voltages Vth1 and Vth2. FIG. 3 also illustrates first through third voltages V1, V2 and V3. FIG. 3 illustrates a characteristic of a drain current vs. a gate voltage (Ids-Vgs) of the oxide semiconductor transistor 10 or 30 when light is not incident or an amount of incident light is at or below a reference level (indicated by the label 'dark' in FIG. 3), and when light is incident or an amount of incident light is at or above a second reference level (indicated by the label 'light' in FIG. 3). Referring to FIG. 3, when light is incident on the oxide semiconductor transistor 10 or 30, it can be seen that a threshold voltage may generally move in a negative direction, for example, based on an amount of the incident light. For example, in the example illustrated in FIG. 3, when light is not incident on the oxide semiconductor transistor or an amount of incident light is at or below a first reference level 10 or 30, the threshold voltage of the oxide semiconductor transistor 10 or 30 is equal to the second threshold voltage Vth2 and is changed to the first threshold voltage Vth1 when light is incident, for example, based on the amount of incident light. Thus, when a gate voltage equal to the second voltage V2 between the first threshold voltage Vth1 and the second threshold voltage Vth2 is applied to the oxide semiconductor transistor 10 or 30, in the 'dark' case, the oxide semiconductor transistor 10 or 30 is may be in an OFF state and thus a relatively low drain current may flow and, in the 'light' case, the oxide semiconductor transistor 10 or 30 is may be in an ON state and thus a relatively high drain current may flow. Further, when a gate voltage equal to the first voltage V1 is applied to the oxide semiconductor transistor 10 or 30, the oxide semiconductor transistor 10 or 30 is in the OFF state regardless of the incidence of light. Also, when a gate voltage equal to the third voltage V3 higher than the first and second threshold voltages Vth1 and Vth2 is applied to the oxide semiconductor transistor 10 or 30, the oxide semiconductor transistor 10 or 30 is in the ON state regardless of the incidence of light.

Thus, in a state in which a gate voltage equal to the second voltage V2 is applied to the oxide semiconductor transistor 10 or 30, the incidence of light may be determined by measuring the drain current. In particular, in the case of the oxide semiconductor transistor 10 or 30, it can be seen that a current ratio (I_{ON}/I_{OFF}) between the drain current when light is incident and the drain current when light is not incident, or below a reference level, may be about 5.2 (log₁₀(10^{-7.2}/10⁻¹²)) which may be large compared to conventional silicon semiconductor photodiodes. When the oxide semiconductor transistor 10 or 30 having such a characteristic is used as a light sensing device, there may be a variety of advantages. For example, since a light sensitivity of the oxide semiconductor transistor 10 or 30 is high, when the oxide semiconductor transistor 10 or 30 is used as a light sensing device, a circuit structure of a light sensing pixel may be much simplified.

For a general silicon photodiode, since a current ratio is relatively low, electric charges generated from a photodiode when light is applied may be accumulated in a capacitor for a predetermined time and then a signal representing light intensity may be generated from the quantity of the electric charges accumulated in the capacitor. Thus, a separate data output and switching drive circuit may be needed to convert the electric charges accumulated in the capacitor into a light intensity signal and output. To this end, a photodiode, a capacitor, and at least one thin film transistor may be arranged for each light sensing pixel. Typically, 3 to 5 thin film transistors may be used for one light sensing pixel to amplify and output a signal without noise.

However, since light sensitivity of the oxide semiconductor transistor 10 of FIG. 1 or the oxide semiconductor transistor 30 of FIG. 2 may be comparatively higher or very high with respect to conventional photodiodes, there may be no need to accumulate electric charges in a capacitor for a predetermined time. Also, since the oxide semiconductor transistor 10 or 30 may be capable of performing a switch function by itself unlike a photodiode, a separate data output and switching drive circuit may not be necessary. Accordingly, the size of a light sensing apparatus using the switch function may be increased, a drive speed may be improved, and consumption of power may be reduced.

FIG. 4 is a graph showing a change in the drain current according to the passage of time after light is incident on the oxide semiconductor transistor 10 or the oxide semiconductor transistor 30, in which a gate voltage Vg of, for example, -5V, between the first and second threshold voltages Vth1 and Vth2, is applied to the oxide semiconductor transistor 10 or 30. In the example illustrated in FIG. 4, light becomes incident on the oxide semiconductor 10 from the 40 second point to approximately the 55 second point. In the example illustrated in FIG. 4, the drain current increases when light is incident on the oxide semiconductor transistor 10 or 30. However, even when the incidence of light discontinues at about 55 seconds, the drain current hardly decreases and rather maintains a similar state to a light incidence state. According to example embodiments, the oxide semiconductor transistor 10 or 30 has a sort of a memory function with respect to the incidence of light. This phenomenon may be understood as one in which electric charges are trapped in or on a boundary surface of the channel layer 15 of the oxide semiconductor transistor 10 or the channel layer 32 of the oxide semiconductor transistor 30. For example, when a negative gate voltage is applied with light to the oxide semiconductor transistor 10 or 30, holes generated by the light in the channel layer 15 or 32 are transferred to a boundary surface between the gate insulation film 14 or 33 and the channel layer 15 or 32 and may be trapped therein. The trapped electric charges may not be removed until a sufficiently large positive voltage is applied to the gate 13 or 34. Thus, once the electric charges are trapped, the drain current may not be lowered even after the incidence of light discontinues. Such a phenomenon may disappear when the trapped electric charges are removed by applying a sufficiently large gate voltage to the oxide semiconductor transistor 10 or 30.

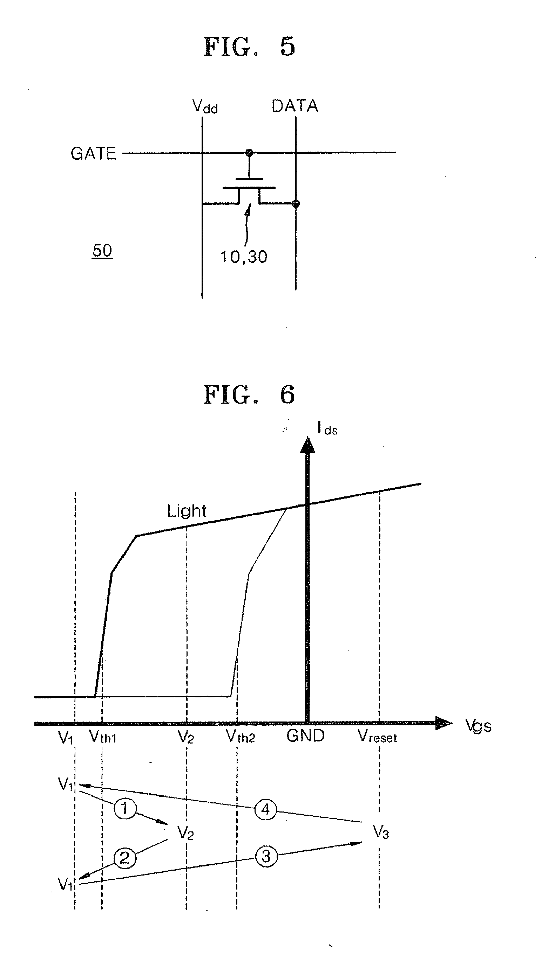

FIG. 5 is a circuit diagram illustrating a structure of a light sensing circuit 50 according to example embodiments. Referring to FIG. 5, the light sensing circuit 50 may include a single oxide semiconductor transistor 10 or 30 having light sensitivity, a gate line GATE connected to the gate 13 or 34 of the oxide semiconductor transistor 10 or 30, a drive voltage line Vdd connected to the drain 17 or 36 of the oxide semiconductor transistor 10 or 30, and a data line DATA connected to the source 16 or 35 of the oxide semiconductor transistor 10 or 30. The light sensing circuit 50 configured as above may be capable of performing a light sensing operation and a switching operation with the single oxide semiconductor transistor 10 or 30 only, as described below. FIG. 5 illustrates the light sensing circuit 50 having only one pixel for convenience of explanation. However, as described below, a plurality of light sensing circuits 50 for a plurality of pixels may be arranged along a plurality of gate lines GATE and a plurality of data lines DATA.

FIG. 6 schematically illustrates operation characteristics and a driving method of the oxide semiconductor transistor 10 or 30 in the light sensing circuit 50 of FIG. 5. Referring to FIG. 6, in a ready state, the first voltage V1 that is negative and lower than the first threshold voltage Vth1 when light is incident is applied to the gate 13 or 34 of the oxide semiconductor transistor 10 or 30 through the gate line GATE. Then, the oxide semiconductor transistor 10 or 30 is always in an OFF state regardless of the incidence of light. As a result, current does not flow from the drain 17 or 36 of the oxide semiconductor transistor 10 or 30 to the source 16 or 35 thereof. Thus, in the interim, current hardly flows to the data line DATA.

Next, during transition '1' illustrated in FIG. 6, for the output of a light sensing signal, the second voltage V2 that is negative and between the first threshold voltage Vth1, which is a threshold voltage during the incidence of light based on an amount of incident light, and the second threshold voltage Vth2, which is a threshold voltage during the non-incidence of light or the incidence of light below a first reference amount, is applied to the gate 13 or 34 of the oxide semiconductor transistor 10 or 30 through the gate line GATE. The second voltage V2 is higher than the first voltage V1. As illustrated in FIG. 6, the oxide semiconductor transistor 10 or 30 is in an ON state when light is incident and in an OFF state when light is not incident.

Thus, when light is incident on the oxide semiconductor transistor 10 or 30, current flows from the drain 17 or 36 to the source 16 or 35. According to example embodiments, current may flow from the drive voltage line Vdd of the light sensing circuit 50 to the data line DATA. The amount of current flowing in the data line DATA may be proportional to the quantity or intensity of incident light. Thus, the existence of incident light and the quantity/intensity of incident light may be identified and calculated by measuring the current flowing toward the data line DATA during when the second voltage V2 is applied to the gate 13 or 34 of the oxide semiconductor transistor 10 or 30. In particular, in order to improve light sensitivity, the second voltage V2 may be selected between the first threshold voltage Vth1 and the second threshold voltage Vth2 to be closer to the second threshold voltage Vth2. When the output of a light sensing signal is completed, during transition '2' illustrated in FIG. 6, the first voltage V1 is applied again to the gate 13 or 34 of the oxide semiconductor transistor 10 or 30 via the gate line GATE. Then, the oxide semiconductor transistor 10 or 30 is in an OFF state regardless of the existence of incident light.

As described above with reference to FIG. 4, once light is incident, the drain current in the oxide semiconductor transistor 10 or 30 is not lowered even when the incidence of light discontinues. Accordingly, after the output of a light sensing signal, for a next light sensing operation, an operation to reset the oxide semiconductor transistor 10 or 30 is performed by applying a sufficiently large amount of a gate voltage to the oxide semiconductor transistor 10 or 30. For example, referring to FIG. 6, during transition '3' illustrated in FIG. 6, a sufficiently large amount of the third voltage V3 is applied to the gate 13 or 34 of the oxide semiconductor transistor 10 or 30 via the gate line GATE. Then, the oxide semiconductor transistor 10 or 30 is reset and thus the next light sensing operation may be performed. Thereafter, during transition '4' illustrated in FIG. 6, the oxide semiconductor transistor 10 or 30 is in a ready state while the first voltage V1 is applied again to the gate 13 or 34 of the oxide semiconductor transistor 10 or 30 until the next light sensing operation is performed.

When the second voltage V2 is applied sequentially to the gate lines GATE using the above principle, the pixel or pixels upon which light is incident among a plurality of pixels may be indentified. As described above, in the light sensing circuit 50 according to example embodiments, one oxide semiconductor transistor 10 or 30 may perform both of light sensing and data output. According to example embodiments, the oxide semiconductor transistor 10 or 30 may simultaneously function as a light sensing device and a drive circuit. Thus, it is possible to provide the light sensing circuit 50 having a structure that is very simplified as illustrated in FIG. 5.

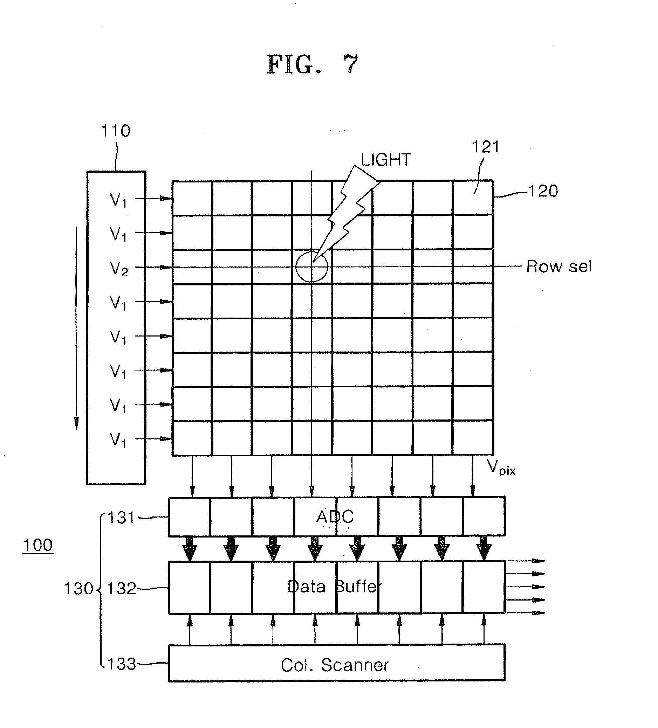

The light sensing circuit 50 may be used for each pixel structure of a light sensing apparatus such as a light touch screen apparatus. FIG. 7 is a block diagram schematically illustrating a structure of a light sensing apparatus 100 according to example embodiments including the light sensing circuit 50 of FIG. 5. Referring to FIG. 7, the light sensing apparatus 100 according to example embodiments may include a light sensing pixel array 120 having a plurality of light sensing pixels 121 for sensing incident light, a gate driver 110 that selectively supplies a gate voltage and a reset signal to each of the light sensing pixels 121, and a signal output unit 130 that receives a light sensing signal from each of the light sensing pixels 121 and outputs a data signal. As illustrated in FIG. 7, the light sensing pixels 121 of the light sensing pixel array 120 may be arranged in a plurality of rows and a plurality of columns. For example, the light sensing pixels 121 may be arranged in an array of n-numbered rows and m-numbered columns. Each of the light sensing pixels 121 may be formed of a single oxide semiconductor transistor 10 or 30, as illustrated in FIG. 5. Also, the signal output unit 130 may include an analog-to-digital (A/D) converter 131 for converting an analog output signal of the light sensing pixels 121 into a digital signal, a data buffer 132 for temporarily storing the digital output signal, and a column scanner 133 for selecting an output from the light sensing pixels 121 of a particular column.

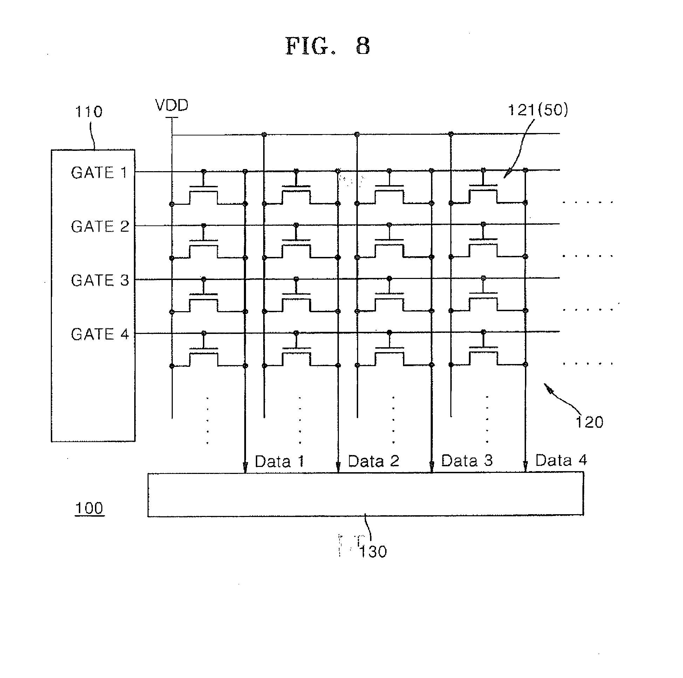

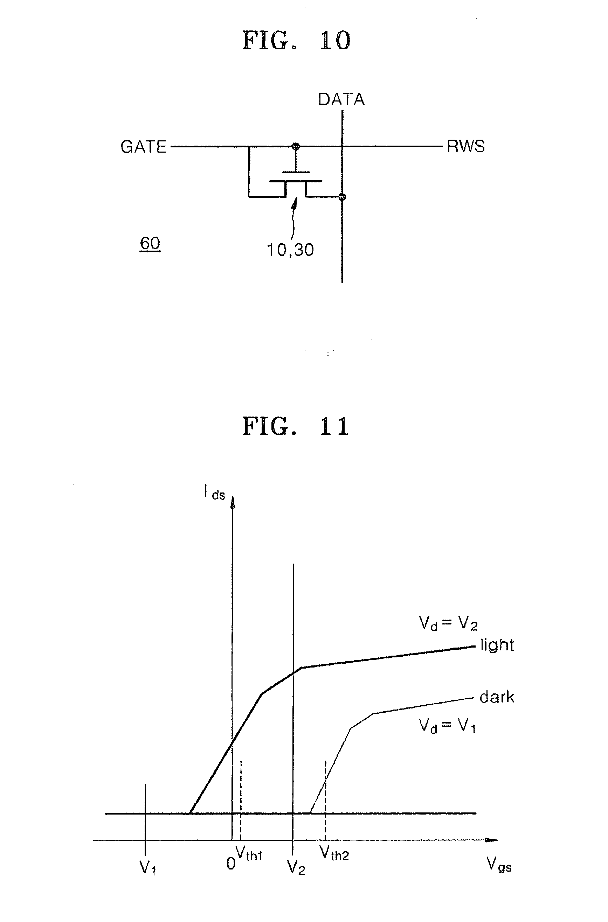

FIG. 8 schematically illustrates a structure of the light sensing pixel array 120 of the light sensing apparatus 100 of FIG. 7. For example, referring to FIG. 8, the light sensing circuit 50 of FIG. 5 is illustrated as being arranged in each of the light sensing pixels 121. However, instead of the light sensing circuit 50 of FIG. 5, a light sensing circuit 60 of FIG. 10 may be arranged in each of the light sensing pixels 121.

Referring to FIGS. 7 and 8, the gate driver 110 may selectively activate each of the light sensing pixels 121 to control each of the light sensing pixels 121 to output a light sensing signal. To this end, the gate driver 110 may include a plurality of gate lines GATE1, GATE2, ..., which are arranged in a row direction. Each gate line may be connected to the gates 13 or 34 of the oxide semiconductor transistor 10 or 30 in all of the light sensing pixels 121 arranged in the same row. For example, the first gate line GATE1 may be connected to the gates 13 or 34 of the oxide semiconductor transistor 10 or 30 in all of the light sensing pixels 121 arranged in the first row, and the second gate line GATE2 may be connected to the gates 13 or 34 of the oxide semiconductor transistor 10 or 30 in all of the light sensing pixels 121 arranged in the second row.

The signal output unit 130 may receive a light sensing signal generated from each of the light sensing pixels 121 and output a data signal. To this end, the signal output unit 130 may include a plurality of data lines Data1, Data2, ..., which are arranged in a column direction. Each of the data lines Data1, Data2, ..., may be connected to the source 16 or 35 of the oxide semiconductor transistor 10 or 30 in all of the light sensing pixels 121 arranged in the same column. For example, the first data line Data1 may be connected to the source 16 or 35 of the oxide semiconductor transistor 10 or 30 in all of the light sensing pixels 121 arranged in the first column, and the second data line Data2 may be connected to the source 16 or 35 of the oxide semiconductor transistor 10 or 30 in all of the light sensing pixels 121 arranged in the second column.

In the above-described structure, the signal output unit 130 may simultaneously receive all light sensing signal generated from the light sensing pixels 121 arranged in the same row through the data lines Data1, Data2, ... For example, when a gate voltage V2 is applied to the first gate line GATE1, all light sensing signals generated from the light sensing pixels 121 arranged in the first row may be simultaneously input to the signal output unit 130.

The signal output unit 130 may be configured to convert the light sensing signals into digital data signals and sequentially output the digital data signals column by column. For example, the output of each of the light sensing pixels 121 is provided to the A/D converter 131 via the corresponding data line DATA which may be connected top the signal output unit 130. A signal from each of the light sensing pixels 121 may have a high amplitude during the incidence of light and low amplitude, for example, close to 0, during the non-incidence of light. Since the signal at this time is an analog signal, the signal is converted into a digital signal by the A/D converter 131. The digital output converted by the A/D converter 131 may be provided to the data butter 132 and stored therein. Then, the column scanner 133 may select a particular column such that only a digital signal of the selected column is output according to the selection of the column scanner 133. For example, FIG. 7 illustrates that a signal of the light sensing pixel 121 located at the third row and fourth column may be selected and output from the buffer 132.

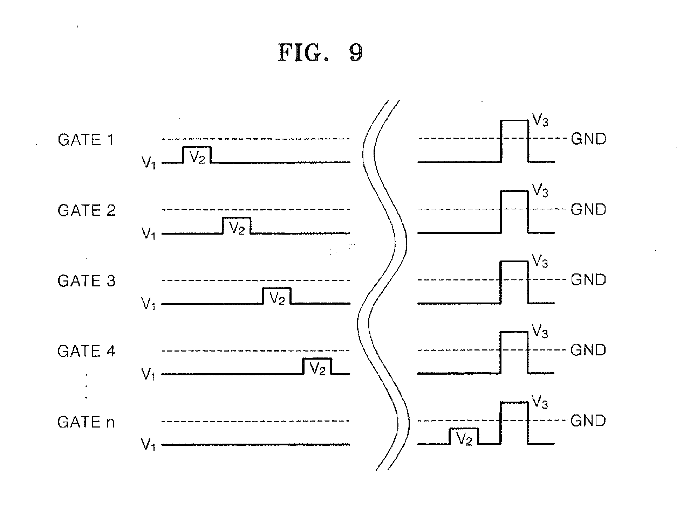

The following description discusses the operation of the above-described light sensing apparatus 100 according to example embodiments. FIG. 9 is a timing diagram showing a method of driving the light sensing apparatus 100 of FIG. 7. Referring to a timing diagram of FIG. 9, first, the gate driver 110 may apply a gate voltage equal to a second voltage V2 between the first and second threshold voltages Vth1 and Vth2 of the oxide semiconductor transistor 10 or 30 to the first gate line GATE1 so that a light sensing signal is output from the light sensing pixels 121 in the first row. A low voltage equal to a first voltage V1 may be applied to the other gate lines GATE2, ... Thus, light sensing signals may not be generated from the light sensing pixels 121 in the other rows. Then, the gate driver 110 may apply a gate voltage V2 to the second gate line GATE2 so that a light sensing signal is output from the light sensing pixels 121 in the second row. A low voltage V1 may be applied to the other gate lines GATE1, GATE3, ... Thus, light sensing signals may be output from the light sensing pixels 121 in order from the first row to the last row of the light sensing pixel array 120 in this manner.

Then, the gate driver 110 may apply a positive reset signal equal to a third voltage V3 to all of the gate lines GATE1, GATE2, ... to reset the oxide semiconductor transistor 10 or 30 of all of the light sensing pixels 121 in the light sensing pixel array 120. Accordingly, the oxide semiconductor transistor 10 or 30 is initialized so that a next light sensing operation may be performed. As a result, a light sensing operation of one frame is completed. When a light sensing operation of one frame is completed, a light sensing operation of a next frame may be repeated in the same order as that described above.

FIG. 10 is a circuit diagram illustrating a structure of a light sensing circuit 60 according to an example useful for understanding of the present invention. FIG. 11 schematically illustrates operation characteristics and a driving method of an oxide semiconductor transistor in the light sensing circuit 60 of FIG. 10. As it can be seen from the characteristic graph in the example illustrated in FIG. 11, in the oxide semiconductor transistor 10 or 30 used in the light sensing circuit 60 of FIG. 10, the first threshold voltage Vth1 during the incidence of light is a negative voltage and the second threshold voltage Vth2 during the non-incidence of light, or the incidence of light below a reference amount, is a positive voltage. Such a threshold voltage characteristic may be selected according to, for example, the material for the channel layer 15 or 32. When the second threshold voltage Vth2 is a positive voltage, the second voltage V2 provided to the gates 13 or 34 of the oxide semiconductor transistor 10 or 30 via the gate line GATE may be a positive voltage. In this case, without applying a separate drive voltage Vdd to the drain 17 or 36 of the oxide semiconductor transistor 10 or 30, the second voltage V2 applied to the gates 13 or 34 may be used as a drive voltage. Thus, the light sensing circuit 60 of FIG. 10 may not separately include a drive voltage Vdd line. The gate line GATE may be simultaneously connected to the gates 13 or 34 and the drain 17 or 36 of the oxide semiconductor transistor 10 or 30. The other structure and operation of the light sensing circuit 60 of FIG. 10 may be the same as those of the light sensing circuit 50 of FIG. 5.

As described above, each of the light sensing pixels 121 of the light sensing apparatus 100 according to example embodiments may simply include only one oxide semiconductor transistor 10 or 30. In the light sensing apparatus 100, the oxide semiconductor transistor 10 or 30 may function not only as a light sensor but also as a switch to output a light sensing signal. Thus, compared to a conventional light sensing apparatus which may have a more complicated circuit structure in which a plurality of transistors and capacitors are installed in one pixel, the structure and operation of the light sensing apparatus 100 according to example embodiments may be much simplified. Accordingly, the light sensing apparatus 100 may be manufactured in a large size overcoming a design limit due to parasitic resistance and parasitic capacitance. Also, an aperture ratio may be improved due to a simplified pixel structure so that sensitivity and resolution of the light sensing apparatus 100 may be improved.

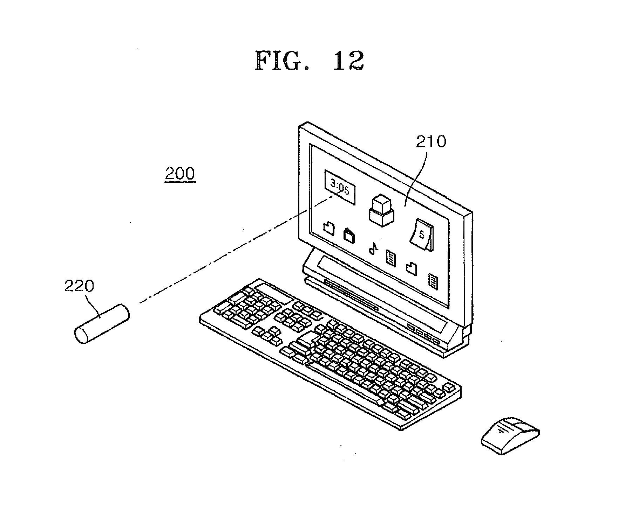

FIG. 12 is a perspective view of an optical touch screen apparatus 200 according to example embodiments in which the light sensing apparatus 100 of FIG. 7 is used, for example, as a light touch panel. Referring to FIG. 12, the optical touch screen apparatus 200 may include a display apparatus 210 in which an optical touch panel formed of the above-described light sensing apparatus 100 is attached to a screen. In the optical touch screen apparatus 200, when light is irradiated to the display apparatus 210 by using a light source apparatus 220 such as a laser pointer, the light sensing pixels 121 arranged in the light sensing apparatus 100 recognize the light. Thus, the same effect as one such as touching a touch screen with a finger or a stylus may be obtained.

The above descriptions focus on the application, to the optical touch screen apparatus 200, of the light sensing apparatus 100 including the light sensing circuit 50 or 60 using the oxide semiconductor transistor 10 or 30. However, the above-described light sensing apparatus 100 may be applied not only to the optical touch screen apparatus 200, but also to other apparatuses including, for example, any or all apparatuses for sensing light.

As described above, according to example embodiments, a light sensing apparatus having a simplified structure, a method of driving the light sensing apparatus, and an optical touch screen apparatus including the light sensing apparatus, are described and illustrated. It should be understood example embodiments described therein should be considered in a descriptive sense only and not for purposes of limitation. Descriptions of features or aspects within example embodiments should typically be considered as available for other similar features or aspects in other example embodiments.

Example embodiments having thus been described, it will be obvious that the same may be varied in many ways.

## Claims

1. A light sensing apparatus, comprising:
a light sensing pixel array (120) including a plurality of light sensing pixels (121) in a plurality of rows and a plurality of columns; and
a gate driver (110) including a plurality of gate lines in a row direction, the gate driver being configured to provide a gate voltage and a reset signal to each of the plurality of light sensing pixels via the plurality of gate lines,
wherein each of the plurality of light sensing pixels (121) includes a light sensing circuit, comprising:
an oxide semiconductor transistor (10,30) including a channel layer (15,32) including an oxide semiconductor material and having a threshold voltage which is dependent on a light quantity of incident light;
wherein the oxide semiconductor transistor (15,32) is configured to operate as a light sensing device that senses light and a switch that outputs light sensing data;
wherein the gate driver (110) is configured to provide the gate voltage to each oxide semiconductor transistor by:
applying a negative second voltage to gates (13,34) of the oxide semiconductor transistors of the plurality of light sensing pixels (121) in a row from among the plurality of rows, and a negative first voltage that is more negative than the second voltage to the gates (13,34) of the oxide semiconductor transistors in other rows from among the plurality of rows;
sequentially applying the second voltage to tne gates (13,34) of the oxide semiconductor transistors of the plurality of light sensing pixels in a next row from among the plurality of rows, and applying the first voltage to the gates of the oxide semiconductor transistors of the plurality of light sensing pixels in rows other than the next row from among the plurality of rows; and
simultaneously applying a positive third voltage to all of the gates (13,34) of the oxide semiconductor transistors of the plurality of the light sensing pixels in the plurality of rows, after the sequential application of the second voltage to the plurality of rows is completed,
wherein the first voltage is lower than a first threshold voltage, and the second voltage is between the first threshold voltage and a second threshold voltage, the first threshold voltage being a threshold voltage of the oxide semiconductor transistor when light is incident on the oxide semiconductor transistor, the second threshold voltage being a threshold voltage of the oxide semiconductor transistor when light is not incident on the oxide semiconductor transistor,
wherein the third voltage is the reset signal to reset the oxide semiconductor transistor and wherein the gate voltage is provided to each oxide semiconductor transistor in order of the first voltage, the second voltage, the first voltage, and the third voltage.

2. A light sensing apparatus according to claim 1 wherein the oxide semiconductor material (15,32) includes one or more of ZnO, InO, SnO, InZnO, ZnSnO, or InSnO, or a material formed by adding at least one of Hf, Zr, Ti, Ta, Ga, Nb, V, Al, and Sn to one of ZnO, InO, SnO, InZnO, ZnSnO, or InSnO.

3. The light sensing apparatus of claim 1 or 2, further comprising:
a gate line connected to a gate of the oxide semiconductor transistor and configured to provide a gate voltage;
a drive voltage line connected to a drain of the oxide semiconductor transistor and configured to provide a drive voltage; and
a data line connected to a source of the oxide semiconductor transistor and configured to provide data.

4. The light sensing apparatus of claim 1 or 2, wherein the oxide semiconductor transistor further includes
a substrate (11);
a gate (13) on at least a portion of the substrate;
a gate insulation film (14) on the substrate and the gate to cover at least the gate;
a source (16) and a drain (17) on opposite sides of the channel layer; and
a transparent insulation layer (18) covering the source, the drain, and the channel layer,
wherein the channel layer (15) is on the gate insulation film (14) and facing the gate (13).

5. The light sensing apparatus of claim 1, 2 or 3 wherein the oxide semiconductor transistor comprises:
a substrate (31);
a gate insulation film (33) on at least a central portion of the channel layer
a gate (34) on the gate insulation film (33) that faces the channel layer (32);
a source (35) and a drain (36) on the channel layer (32) at opposite sides of the gate (34), the source and drain each being separate from the gate; and
a transparent insulation layer (37) covering the gate (34), the source (35), and the drain (36),
wherein the channel layer (32) is on the substrate (31).

6. The light sensing apparatus of any preceding claim wherein each gate line is connected to light sensing pixels (121), from among the plurality of light sensing pixels, that are in the same row,
wherein gates (13,34) of the oxide semiconductor transistors of the plurality of light sensing pixels in a row are connected to the gate line of the same row.

7. The light sensing apparatus of any preceding claim, further comprising a signal output unit (130) that includes a plurality of data lines in a column direction, the signal output unit being configured to receive a light sensing signal from each of the plurality of light sensing pixels and output a data signal,
wherein sources (16,35) of the oxide semiconductor transistors of the plurality of light sensing pixels in a column are connected to the data line of the same column.

8. The light sensing apparatus of claim 7, wherein the signal output unit (130) includes
an A/D converter (131) configured to convert analog signals output from the plurality of light sensing pixels into digital signals;
a buffer (132) configured to temporarily store the digital signals; and
a column scanner (133) configured to select an output from one of the plurality of light sensing pixels in a column.

9. An optical touch screen apparatus, comprising:
a display apparatus (210) configured to display an image;
an optical touch panel attached on a screen of the display apparatus, the optical touch panel including the light sensing apparatus of any of claims 1 to 8 and
a light source apparatus (220) configured to provide an optical signal to the optical touch panel.

10. A method of driving a light sensing apparatus, the light sensing apparatus comprising a plurality of light sensing pixels (121) in a plurality of rows and a plurality of columns, each of the light sensing pixels (121) including an oxide semiconductor transistor (10,30) including a channel layer (15, 32) including an oxide semiconductor material having a threshold voltage which is dependent on a light quantity of incident light, that operates as both a light sensing device sensing light and a switch outputting light sensing data, the method comprising: applying a negative second voltage to gates (13,34) of the oxide semiconductor transistors of the plurality of light sensing pixels (121) in a row from among the plurality of rows, and a negative first voltage that is more negative than the second voltage to the gates (13,34) of the oxide semiconductor transistors in other rows from among the plurality of rows;
sequentially applying the second voltage to the gates (13,34) of the oxide semiconductor transistors of the plurality of light sensing pixels in a next row from among the plurality or rows, and applying the first voltage to the gates of the oxide semiconductor transistors of the plurality of light sensing pixels in rows other than the next row from among the plurality of rows; and
simultaneously applying a positive third voltage to all of the gates (13,34) of the oxide semiconductor transistors of the plurality of the light sensing pixels in all the rows, after the sequential application of the second voltage to all rows is completed,
wherein the first voltage is lower than a first threshold voltage, and the second voltage is between the first threshold voltage and a second threshold voltage, the first threshold voltage being a threshold voltage of the oxide semiconductor transistor when light is incident on the oxide semiconductor transistor, the second threshold voltage being a threshold voltage of the oxide semiconductor transistor when light not incident on the oxide semiconductor transistor,
wherein the third voltage is a reset signal that resets the oxide semiconductor transistor,
wherein the gate voltage is provided to each oxide semiconductor transistor in order of the first voltage, the second voltage, the first voltage, and the third voltage.

11. The method of claim 10, further comprising:
measuring current flowing between a drain and a source of the oxide semiconductor transistor during the application of the second voltage to a gate of the oxide semiconductor transistor.

## Patentansprüche

1. Lichtempfindliche Vorrichtung, die Folgendes umfasst:
eine lichtempfindliche Pixelmatrix (120), die eine Vielzahl lichtempfindlicher Pixel (121) in einer Vielzahl von Zeilen und einer Vielzahl von Spalten umfasst; und
einen Gate-Treiber (110), der eine Vielzahl von Gate-Leitungen in einer Zeilenrichtung umfasst, wobei der Gate-Treiber so konfiguriert ist, dass er über die Vielzahl der Gate-Leitungen an jedes der Vielzahl der lichtempfindlichen Pixel eine Gate-Spannung und ein Reset-Signal liefert,
wobei jedes der Vielzahl der lichtempfindlichen Pixel (121) einen lichtempfindlichen Schaltkreis enthält, der Folgendes umfasst:
einen Oxid-Halbleiter-Transistor (10, 30) der eine Kanalschicht (15, 32) mit einem Oxid-Halbleiter-Material umfasst und eine Schwellenspannung aufweist, die von der Lichtquantität des einfallenden Lichts abhängig ist;
wobei der Oxid-Halbleiter-Transistor (15, 32) so konfiguriert ist, dass er als lichtempfindliches Gerät, das Licht wahrnehmen kann und als Schalter, der lichtempfindliche Daten ausgibt, fungiert;
wobei der Gate-Treiber (110) so konfiguriert ist, dass er die Gate-Spannung an jeden Oxid-Halbleiter-Transistor liefert, indem:
eine negative zweite Spannung an die Gates (13, 34) der Oxid-Halbleiter-Transistoren der Vielzahl der lichtempfindlichen Pixel (121) in einer Zeile innerhalb der Vielzahl der Zeilen angelegt wird und eine negative erste Spannung, die negativer als die zweite Spannung ist, an die Gates (13, 34) der Oxid-Halbleiter-Transistoren in anderen Zeilen innerhalb der Vielzahl der Zeilen angelegt wird;
sequenziell die zweite Spannung an die Gates (13, 34) der Oxid-Halbleiter-Transistoren der Vielzahl der lichtempfindlichen Pixel in einer nächsten Zeile innerhalb der Vielzahl der Zeilen angelegt wird und die erste Spannung an die Gates der Oxid-Halbleiter-Transistoren der Vielzahl der lichtempfindlichen Pixel in anderen Zeilen als der nächsten Zeile innerhalb der Vielzahl der Zeilen angelegt wird; und
gleichzeitig eine positive dritte Spannung an alle Gates (13, 34) der Oxid-Halbleiter-Transistoren der Vielzahl der lichtempfindlichen Pixel in der Vielzahl der Zeilen angelegt wird, nachdem das sequenzielle Anlegen der zweiten Spannung für die Vielzahl der Zeilen abgeschlossen ist,
wobei die erste Spannung niedriger als eine erste Schwellenspannung ist und die zweite Spannung zwischen der ersten Schwellenspannung und einer zweiten Schwellenspannung liegt, wobei die erste Schwellenspannung eine Schwellenspannung des Oxid-Halbleiter-Transistors ist, wenn Licht auf den Oxid-Halbleiter-Transistor einfällt und wobei die zweite Schwellenspannung eine Schwellenspannung des Oxid-Halbleiter-Transistors ist, wenn kein Licht auf den Oxid-Halbleiter-Transistor einfällt,
wobei die dritte Spannung das Reset-Signal für das Zurücksetzen des Oxid-Halbleiter-Transistors ist und wobei die Gate-Spannung für jeden Oxid-Halbleiter-Transistor in der Reihenfolge der ersten Spannung, der zweiten Spannung, der ersten Spannung und der dritten Spannung geliefert wird.

2. Lichtempfindliche Vorrichtung nach Anspruch 1, wobei das Oxid-Halbleiter-Material (15, 32) eines oder mehrere der Folgenden umfasst: ZnO, InO, SnO, InZnO, ZnSnO oder InSnO oder ein Material, dass durch Hinzufügung von mindestens einem der Folgenden: Hf, Zr, Ti, Ta, Ga, Nb, V, Al zu einem der Folgenden: ZnO, InO, SnO, InZnO, ZnSnO oder InSnO gebildet wird.

3. Lichtempfindliche Vorrichtung nach Anspruch 1 oder 2, die zudem Folgendes umfasst:
eine Gate-Leitung, die mit einem Gate des Oxid-Halbleiter-Transistors verbunden ist und so konfiguriert ist, dass Sie eine Gate-Spannung liefert;
eine Leitung für die Antriebsspannung, die mit einem Drain des Oxid-Halbleiter-Transistors verbunden ist und so konfiguriert ist, dass sie eine Antriebsspannung liefert; und
eine Datenleitung, die mit einer Source des Oxid-Halbleiter-Transistors verbunden und so konfiguriert ist, dass sie Daten liefert.

4. Lichtempfindliche Vorrichtung nach Anspruch 1 oder 2, wobei der Oxid-Halbleiter-Transistor zudem Folgendes umfasst:
ein Substrat (11);
ein Gate (13) auf mindestens einem Abschnitt des Substrats;
eine Gate-Isolationsfolie (14) auf dem Substrat und dem Gate, um mindestens das Gate abzudecken;
eine Source (16) und ein Drain (17) an gegenüberliegenden Seiten der Kanalschicht; und
eine transparente Isolationsschicht (18), welche die Source, den Drain und die Kanalschicht abdeckt,
wobei sich die Kanalschicht (15) auf der Gate-Isolationsfolie (14) befindet und gegenüber dem Gate (13) liegt.

5. Lichtempfindliche Vorrichtung nach Anspruch 1, 2 oder 3, wobei der Oxid-Halbleiter-Transistor Folgendes umfasst:
ein Substrat (31);
eine Gate-Isolationsfolie (33) auf mindestens einem zentralen Abschnitt der Kanalschicht;
ein Gate (34) auf der Gate-Isolationsfolie (33), welches gegenüber der Kanalschicht (32) liegt;
eine Source (35) und ein Drain (36) auf der Kanalschicht (32) an gegenüberliegenden Seiten des Gates (34), wobei die Source und der Drain jeweils vom Gate getrennt sind; und
eine transparente Isolationsschicht (37), welche das Gate (34), die Source (35) und den Drain (36) abdeckt,
wobei sich die Kanalschicht (32) auf dem Substrat (31) befindet.

6. Lichtempfindliche Vorrichtung nach einem beliebigen der vorhergehenden Ansprüche, wobei jede Gate-Leitung mit lichtempfindlichen Pixeln (121) aus der Vielzahl der lichtempfindlichen Pixel verbunden ist, die auf der gleichen Zeile liegen,
wobei Gates (13, 34) der Oxid-Halbleiter-Transistoren der Vielzahl der lichtempfindlichen Pixel in einer Zeile mit der Gate-Leitung aus der gleichen Zeile verbunden sind.

7. Lichtempfindliche Vorrichtung nach einem beliebigen der vorhergehenden Ansprüche, die zudem eine Signalausgabeeinheit (130) mit einer Vielzahl von Datenleitungen in einer Spaltenrichtung umfasst, wobei die Signalausgabeeinheit so konfiguriert ist, dass sie von jedem der Vielzahl der lichtempfindlichen Pixel ein lichtempfindliches Signal empfängt und ein Datensignal ausgibt,
wobei die Sources (16, 35) der Oxid-Halbleiter-Transistoren der Vielzahl der lichtempfindlichen Pixel in einer Spalte mit der Datenleitung der gleichen Spalte verbunden sind.

8. Lichtempfindliche Vorrichtung nach Anspruch 7, wobei die Signalausgabeeinheit (130) Folgendes umfasst:
einen A/D-Wandler (131), der so konfiguriert ist, dass er analoge Signale, die von der Vielzahl der lichtempfindlichen Pixel ausgegeben werden, in digitale Signale umwandelt;
einen Puffer (132), der so konfiguriert ist, dass er die digitalen Signale vorübergehend speichern kann; und
einen Spalten-Scanner (133), der so konfiguriert ist, dass er die Ausgabe von einer der Vielzahl der lichtempfindlichen Pixel in einer Spalte auswählt.

9. Vorrichtung mit optischem Touchscreen, die Folgendes umfasst:
eine Displayvorrichtung (210), die so konfiguriert ist, dass sie ein Bild anzeigt;
ein optisches Touchbedienfeld, das an einem Bildschirm der Displayvorrichtung angebracht ist, wobei das optische Touchbedienfeld die lichtempfindliche Vorrichtung nach einem beliebigen der Ansprüche 1 bis 8 umfasst und
eine Lichtquellenvorrichtung (220), die so konfiguriert ist, dass sie ein optisches Signal an das optische Touchbedienfeld liefert.

10. Verfahren für den Antrieb einer lichtempfindlichen Vorrichtung, wobei die lichtempfindliche Vorrichtung eine Vielzahl lichtempfindlicher Pixel (121) in einer Vielzahl von Zeilen und einer Vielzahl von Spalten umfasst, wobei jedes der lichtempfindlichen Pixel (121) einen Oxid-Halbleiter-Transistor (10, 30) mit einer Kanalschicht (15, 32) umfasst, die ein Oxid-Halbleiter-Material umfasst und eine Schwellenspannung aufweist, die von der Lichtquantität des einfallenden Lichts abhängig ist, wobei dieser sowohl als lichtempfindliches Gerät, das Licht wahrnehmen kann als auch als Schalter, der lichtempfindliche Daten ausgibt, fungiert, wobei das Verfahren Folgendes umfasst: das Anlegen einer negativen zweiten Spannung an die Gates (13, 34) der Oxid-Halbleiter-Transistoren der Vielzahl der lichtempfindlichen Pixel (121) in einer Zeile innerhalb der Vielzahl der Zeilen und das Anlegen einer negativen ersten Spannung an die Gates (13, 34) der Oxid-Halbleiter-Transistoren in anderen Zeilen innerhalb der Vielzahl der Zeilen, die negativer als die zweite Spannung ist;
das sequenzielle Anlegen der zweiten Spannung an die Gates (13, 34) der Oxid-Halbleiter-Transistoren der Vielzahl der lichtempfindlichen Pixel in einer nächsten Zeile innerhalb der Vielzahl der Zeilen und das Anlegen der ersten Spannung an die Gates der
Oxid-Halbleiter-Transistoren der Vielzahl der lichtempfindlichen Pixel in anderen Zeilen als der nächsten Zeile innerhalb der Vielzahl der Zeilen; und
das gleichzeitige Anlegen einer positiven dritten Spannung an alle Gates (13, 34) der Oxid-Halbleiter-Transistoren der Vielzahl der lichtempfindlichen Pixel in allen Zeilen, nachdem das sequenzielle Anlegen der zweiten Spannung für alle Zeilen abgeschlossen ist,
wobei die erste Spannung niedriger als eine erste Schwellenspannung ist und die zweite Spannung zwischen der ersten Schwellenspannung und einer zweiten Schwellenspannung liegt, wobei die erste Schwellenspannung eine Schwellenspannung des Oxid-Halbleiter-Transistors ist, wenn Licht auf den Oxid-Halbleiter-Transistor einfällt und wobei die zweite Schwellenspannung eine Schwellenspannung des Oxid-Halbleiter-Transistors ist, wenn kein Licht auf den Oxid-Halbleiter-Transistor einfällt,
wobei die dritte Spannung das Reset-Signal für das Zurücksetzen des Oxid-Halbleiter-Transistors ist,
wobei die Gate-Spannung für jeden Oxid-Halbleiter-Transistor in der Reihenfolge der ersten Spannung, der zweiten Spannung, der ersten Spannung und der dritten Spannung geliefert wird.

11. Verfahren nach Anspruch 10, das zudem Folgendes umfasst:
das Messen des Stroms, der zwischen einem Drain und einer Source des Oxid-Halbleiter-Transistors fließt, während die zweite Spannung an ein Gate des Oxid-Halbleiter-Transistors angelegt wird.

## Revendications

1. Un appareil photosensible, composé :
d'un réseau de pixels photosensibles (120) comprenant une série de pixels photosensibles (121) dans une série de rangées et une série de colonnes ; et
d'un circuit d'attaque de grille (110) comprenant une série de lignes de grille dans la direction des lignes, le circuit d'attaque de grille étant configuré pour fournir une tension de grille et un signal de réarmement pour chacun de la série de pixels photosensibles par le biais de la série de lignes de grille,
dans lequel chacun de la série de pixels photosensibles (121) comprend un circuit photosensible, composé :
d'un transistor à oxyde-semi-conducteur (10, 30) comprenant une couche de canal (15, 32) comprenant une matière à oxyde-semi-conducteur à présentant une tension de seuil tributaire d'une légère quantité de lumière incidente ;
dans lequel le transistor à oxyde-semi-conducteur (15, 32) est configuré pour fonctionner comme dispositif photosensible détectant la lumière et commutateur de sortie de données de détection de la lumière ;
dans lequel le circuit d'attaque de grille (110) est configuré pour amener une tension de grille à chaque transistor à oxyde-semi-conducteur :
en appliquant une deuxième tension négative aux grilles (13, 34) des transistors oxyde-semi-conducteur de la série de pixels photosensibles (121) dans une rangée de la série de rangées, et une première tension négative plus négative que la deuxième tension des grilles (13,34) des transistors à oxyde-semi-conducteur d'autres rangées de la série de rangées ;
en appliquant en séquence la deuxième tension aux grilles (13,34) des transistors à oxyde-semi-conducteur de la série de pixels photosensibles dans une rangée suivante de la série de rangées, et en appliquant la première tension aux grilles des transistors à oxyde-semi-conducteur de la série de pixels photosensibles dans des rangées autres que la rangée suivante parmi la série de rangées ; et
en appliquant simultanément une troisième tension positive à toutes les grilles (13, 34) des transistors à oxyde-semi-conducteur de la série de pixels photosensibles dans la série de rangées, après avoir effectué l'application séquentielle de la deuxième tension à la série de rangées,
où la première tension est inférieure à une première tension de seuil, et la deuxième tension est comprise entre la première tension de seuil et une deuxième tension de seuil, la première tension de seuil étant une tension de seuil du transistor à oxyde-semi-conducteur lorsqu'une lumière est incidente sur le transistor à oxyde-semi-conducteur, la deuxième tension de seuil étant une tension de seuil du transistor à oxyde-semi-conducteur lorsqu'une lumière n'est pas incidente sur le transistor à oxyde-semi-conducteur,
où d'une part la troisième tension est le signal de réarmement servant à réarmer le transistor à oxyde-semi-conducteur, d'autre part la tension de grille est amenée à chaque transistor à oxyde-semi-conducteur dans l'ordre première tension, deuxième tension, première tension et troisième tension.

2. Un appareil photosensible selon la revendication 1, dans lequel la matière de l'oxyde-semi-conducteur (15, 32) comprend un ou plusieurs des suivantes : ZnO, InO, SnO, InZnO, ZnSnO, ou InSnO, ou une matière constituée en ajoutant au moins un des suivantes : Hf, Zr, Ti, Ta, Ga, Nb, V, Al, et Sn à une des suivantes : ZnO, InO, SnO, InZnO, ZnSnO, ou InSnO.

3. L'appareil photosensible selon la revendication 1 ou 2, comprenant également :
une ligne de grille reliée à une grille du transistor à oxyde-semi-conducteur, et configurée pour fournir une tension de grille ;
une tension d'attaque reliée à un drain du transistor à oxyde-semi-conducteur et configurée pour fournir une tension d'attaque ; et
une ligne de données reliée à une source du transistor oxyde-semi-conducteur, et configurée pour fournir des données.

4. L'appareil photosensible selon la revendication 1 ou 2, dans lequel le transistor à oxyde-semi-conducteur comprend en outre
un substrat (11) ;
une grille (13) sur au moins une partie du substrat ;
un film isolant de grille (14) sur le substrat et la grille pour couvrir au moins la grille ; une source (16) et un drain (17) sur des côtés opposés de la couche de canal ; et
une couche isolante transparente (18) couvrant la source, le drain et la couche de canal,
dans lequel la couche de canal (15) se trouve sur le film isolant de grille (14) en faisant face à la grille (13).

5. L'appareil photosensible selon la revendication 1, 2 ou 3, dans lequel le transistor à oxyde-semi-conducteur comprend :
un substrat (31) ;
un film isolant de grille (33) sur au moins une partie centrale de la couche de canal ;
une grille (34) sur le film isolant de grille (33) faisant face à la couche de canal (32) ;
une source (35) et un drain (36) sur la couche de canal (32) sur des côtés opposés de la grille (34), la source et le drain étant chacun séparé de la grille ; et
une couche isolante transparente (37) couvrant la grille (34), la source (35) et le drain (36),
dans lequel la couche de canal (32) se trouve sur le substrat (31).

6. L'appareil photosensible selon une quelconque des revendications précédentes, dans lequel chaque ligne de grille est reliée à des pixels photosensibles (121) parmi la série de pixels photosensibles situés sur la même rangée,
dans lequel les grilles (13, 34) des transistors à oxyde-semi-conducteur de la série de pixels photosensibles dans une rangée sont reliées à la ligne de grille de la même rangée.

7. L'appareil photosensible selon une quelconque des revendications précédentes, comprenant en outre un dispositif d'émission de signal (130) comprenant une série de lignes de données dans une direction de colonne, le dispositif d'émission de signal étant configuré pour recevoir un signal photosensible de chacun d'une série de pixels photosensibles et produire un signal de données,
où des sources (16, 35) des transistors oxyde-semi-conducteur de la série de pixels photosensibles dans une colonne sont reliées à la ligne de données de la même colonne.

8. L'appareil photosensible de la revendication 7, dans lequel le dispositif d'émission de signal (130) comprend
un convertisseur A/N (131) configuré pour convertir des signaux analogiques de la série de pixels photosensibles en signaux numériques ;
une mémoire tampon (132) configurée pour mémoriser provisoirement les signaux numériques ; et
un scanner de colonne (133) configuré pour sélectionner une sortie d'un pixel photosensible de la série de pixels photosensibles dans une colonne.

9. Un écran tactile optique, comprenant :
un appareil d'affichage (210) configuré pour afficher une image ;
un panneau tactile optique fixé sur un écran de l'appareil tactile, le panneau tactile optique comprenant l'appareil photosensible d'une quelconque des revendications 1 à 8 et
un appareil à source lumineuse (220) configuré pour fournir un signal optique au panneau tactile optique.

10. Une méthode de commande d'un appareil photosensible, l'appareil photosensible comprenant une série de pixels photosensibles (121) dans une série de rangées et une série de colonnes, chacun des pixels photosensibles (121) comprenant un transistor à oxyde-semi-conducteur (10, 30), y compris une couche de canal (15, 32) comprenant un matériau oxyde-semi-conducteur avec une tension de seuil qui est tributaire d'une légère quantité de lumière incidente, fonctionnant à la fois comme lumière de captage de dispositif capteur de lumière et un commutateur émettant des données de captage de lumière, cette méthode comprenant : l'application d'une deuxième tension négative à des grilles (13, 34) des transistors à oxyde-semi-conducteur de la série de pixels photosensibles (121) dans une rangée faisant partie d'une série de rangées, et d'une première tension négative plus négative que la deuxième tension aux grilles (13, 34) des transistors à oxyde-semi-conducteur dans d'autres rangées de la série de rangées ;
l'application séquentielle de la deuxième tension aux grilles (13,34) des transistors à oxyde-semi-conducteur de la série de pixels photosensibles dans une rangée suivante de la série de rangées, et l'application de la première tension aux grilles des transistors à oxyde-semi-conducteur de la série de pixels photosensibles dans des rangées autres que la rangée suivante parmi la série de rangées ; et
l'application simultanée d'une une troisième tension positive à toutes les grilles (13, 34) des transistors à oxyde-semi-conducteur de la série de pixels photosensibles dans toutes les rangées, après l'application séquentielle de la deuxième tension à toutes les rangées,
où la première tension est inférieure à une première tension de seuil, et la deuxième tension est comprise entre la première tension de seuil et une deuxième tension de seuil, la première tension de seuil étant une tension de seuil du transistor à oxyde-semi-conducteur lorsqu'une lumière est incidente sur le transistor à oxyde-semi-conducteur, la deuxième tension de seuil étant une tension de seuil du transistor à oxyde-semi-conducteur lorsqu'une lumière n'est pas incidente sur le transistor à oxyde-semi-conducteur,
où la troisième tension est un signal de réarmement servant à réarmer le transistor à oxyde-semi-conducteur,
où la tension de grille est amenée à chaque transistor à oxyde-semi-conducteur dans l'ordre première tension, deuxième tension, première tension et troisième tension.

11. La méthode selon la revendication 10, comprenant également :
la mesure du courant s'écoulant entre un drain et une source du transistor à oxyde-semi-conducteur au cours de l'application de la deuxième tension à une grille du transistor à oxyde-semi-conducteur.
